(19) Europäisches Patentamt
European Patent Office
Office européen des brevets

(11) EP 4 293 070 A1

(12) EUROPEAN PATENT APPLICATION
published in accordance with Art. 153(4) EPC

(43) Date of publication:
**20.12.2023 Bulletin 2023/51**

(21) Application number: **22752726.4**

(22) Date of filing: **07.02.2022**

(51) International Patent Classification (IPC):
***C08J 7/00*** *(2006.01)* ***C08F 214/26*** *(2006.01)*
***H05K 1/03*** *(2006.01)*

(52) Cooperative Patent Classification (CPC):
**C08F 8/00; C08F 214/26; C08J 3/20; C08J 7/00; C08K 3/013; C08K 3/22; C08K 3/34; C08L 27/18; H05K 1/03**

(86) International application number:
**PCT/JP2022/004759**

(87) International publication number:
**WO 2022/172903 (18.08.2022 Gazette 2022/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.02.2021 JP 2021020785**

(71) Applicant: **Daikin Industries, Ltd.**
**Osaka-Shi, Osaka 530-0001 (JP)**

(72) Inventors:
- **SAWAKI, Kyouhei**
**Osaka-Shi, Osaka 530-8323 (JP)**
- **OKUNO, Shingo**
**Osaka-Shi, Osaka 530-8323 (JP)**
- **UEDA, Yuki**
**Osaka-Shi, Osaka 530-8323 (JP)**
- **OKANISHI, Ken**
**Osaka-Shi, Osaka 530-8323 (JP)**
- **FUKUSHIMA, Toshiyuki**
**Osaka-Shi, Osaka 530-8323 (JP)**
- **IMAMURA, Hitoshi**
**Osaka-Shi, Osaka 530-8323 (JP)**

(74) Representative: **Hoffmann Eitle**
**Patent- und Rechtsanwälte PartmbB**
**Arabellastraße 30**
**81925 München (DE)**

# (54) MODIFIED FLUORORESIN MATERIAL, MATERIAL FOR CIRCUIT BOARD, LAMINATE FOR CIRCUIT BOARD, CIRCUIT BOARD, AND METHOD FOR PRODUCING MODIFIED FLUORORESIN MATERIAL

(57) Provided is a novel modified fluororesin material having a low linear expansion coefficient, a material for a circuit board, a laminate for a circuit board, a circuit board, and a method for producing the modified fluororesin material. The modified fluororesin material contains a modified fluororesin. The modified fluororesin contains a tetrafluoroethylene unit, a modifying monomer unit based on a modifying monomer copolymerizable with tetrafluoroethylene, and a tertiary carbon atom. The tertiary carbon atom is present in an amount of 0.001 to 0.100 mol% of a total amount of the tetrafluoroethylene unit and the modifying monomer unit. The modified fluororesin material has a linear expansion coefficient at 20°C to 200°C that is 5% or more lower than that of a non-modified fluororesin material. The non-modified fluororesin material contains a tetrafluoroethylene unit and a modifying monomer unit based on a modifying monomer copolymerizable with tetrafluoroethylene and containing no tertiary carbon atom.

EP 4 293 070 A1

## Description

TECHNICAL FIELD

The disclosure relates to modified fluororesin materials, materials for circuit boards, laminates for circuit boards, circuit boards, and methods for producing the modified fluororesin materials.

BACKGROUND ART

Speeding up of communication generates a demand for low dielectric, low loss materials for circuit boards to be used in devices such as electrical devices, electronic devices, and communicating devices.
Patent Literature 1 discloses a high frequency printed wiring board including a laminate of a fluororesin (FEP) and a copper film, the printed wiring board being obtained by irradiating the laminate with ionizing radiation while the fluororesin is in a molten state so as to achieve higher adhesion.
Patent Literature 2 discloses a high frequency printed wiring board including a dielectric layer including an intermediate layer of glass cloth and on each surface thereof a resin layer of fluororesin (FEP).

CITATION LIST

- Patent Literature

Patent Literature 1: JP 2015-8260 A
Patent Literature 2: JP 2015-8286 A

SUMMARY OF INVENTION

- Technical Problem

The disclosure aims to provide a novel modified fluororesin material having a low linear expansion coefficient, a material for a circuit board, a laminate for a circuit board, a circuit board, and a method for producing the modified fluororesin material.

- Solution to Problem

The disclosure relates to a modified fluororesin material containing a modified fluororesin, the modified fluororesin containing: a tetrafluoroethylene unit; a modifying monomer unit based on a modifying monomer copolymerizable with tetrafluoroethylene; and a tertiary carbon atom, the tertiary carbon atom being present in an amount of 0.001 to 0.100 mol% of a total amount of the tetrafluoroethylene unit and the modifying monomer unit, the modified fluororesin material having a linear expansion coefficient at 20°C to 200°C that is 5% or more lower than that of a non-modified fluororesin material, the non-modified fluororesin material containing a tetrafluoroethylene unit and a modifying monomer unit based on a modifying monomer copolymerizable with tetrafluoroethylene and containing no tertiary carbon atom.
The linear expansion coefficient at 20°C to 200°C of the modified fluororesin material is preferably 10% or more lower than that of the non-modified fluororesin material.
The tertiary carbon atom is preferably a carbon atom coupled with F* in a structure represented by $-CF_2CF^*(-CF_2-)CF_2-$ in the modified fluororesin.
The modifying monomer is preferably a monomer containing a perfluorovinyl group.
The monomer containing a perfluorovinyl group preferably includes at least one selected from the group consisting of a perfluoro(alkyl vinyl ether), hexafluoropropylene, and perfluoroallyl ether.
The modified fluororesin material preferably further contains an inorganic filler.
The inorganic filler preferably includes at least one selected from the group consisting of silica, alumina, titanium oxide, and talc.
The modified fluororesin material also preferably further contains a resin other than the modified fluororesin.
The resin other than the modified fluororesin preferably includes at least one selected from the group consisting of poly(paraphenylenebenzoxazole), polybenzimidazole, polyimide, epoxy resin, and polytetrafluoroethylene.
The disclosure also relates to a material for a circuit board, the material containing the modified fluororesin material.

The material for a circuit board is preferably in a form of a sheet.
The material for a circuit board is preferably in a form of a sheet having a thickness of 5 to 3000 μm.
The disclosure also relates to a laminate for a circuit board, the laminate including: a metal layer (A1); and a layer (B) containing the material for a circuit board.
The metal layer (A1) preferably contains copper as a metal component thereof.
The laminate for a circuit board is preferably in a form of a sheet having a thickness of 10 to 3500 μm.
The disclosure also relates to a circuit board including: a metal layer (A2); and a layer (B) containing the material for a circuit board.
The metal layer (A2) preferably contains copper as a metal component thereof.
The circuit board is preferably in a form of a sheet having a thickness of 10 to 3500 μm.
The circuit board is preferably a printed circuit board.
The disclosure also relates to a method for producing the modified fluororesin material, the method including: (1) irradiating a fluororesin with radiation at an irradiation temperature that is 5°C or more lower than a melting point of the fluororesin, the fluororesin being a copolymer containing a tetrafluoroethylene unit and a modifying monomer unit based on a modifying monomer copolymerizable with tetrafluoroethylene.
The step (1) preferably includes irradiating a mixture with the radiation, the mixture containing the fluororesin and at least one selected from the group consisting of an inorganic filler and a resin other than the fluororesin.
The radiation is preferably applied at a dose of 10 kGy to 250 kGy.
The radiation is preferably an electron beam.
The disclosure also relates to a method for producing the modified fluororesin material, the method including: (2) mixing the modified fluororesin and at least one selected from the group consisting of an inorganic filler and a resin other than the modified fluororesin.

- Advantageous Effects of Invention

The disclosure can provide a novel modified fluororesin material having a low linear expansion coefficient, a material for a circuit board, a laminate for a circuit board, a circuit board, and a method for producing the modified fluororesin material.

## DESCRIPTION OF EMBODIMENTS

The "organic group" herein means a group containing at least one carbon atom or a group formed by removing one hydrogen atom from an organic compound.
Examples of this "organic group" include

an alkyl group optionally containing at least one substituent,
an alkenyl group optionally containing at least one substituent,
an alkynyl group optionally containing at least one substituent,
a cycloalkyl group optionally containing at least one substituent,
a cycloalkenyl group optionally containing at least one substituent,
a cycloalkadienyl group optionally containing at least one substituent,
an aryl group optionally containing at least one substituent,
an aralkyl group optionally containing at least one substituent,
a non-aromatic heterocyclic group optionally containing at least one substituent,
a heteroaryl group optionally containing at least one substituent,
a cyano group,
a formyl group,
RaO-,
RaCO-,
$RaSO_2$-,
RaCOO-,
RaNRaCO-,
RaCONRa-,
RaOCO-,
$RaOSO_2$-, and
$RaNRbSO_2$-,

wherein

the Ra groups are each independently
an alkyl group optionally containing at least one substituent,
an alkenyl group optionally containing at least one substituent,
an alkynyl group optionally containing at least one substituent,
a cycloalkyl group optionally containing at least one substituent,
a cycloalkenyl group optionally containing at least one substituent,
a cycloalkadienyl group optionally containing at least one substituent,
an aryl group optionally containing at least one substituent,
an aralkyl group optionally containing at least one substituent,
a non-aromatic heterocyclic group optionally containing at least one substituent, or
a heteroaryl group optionally containing at least one substituent; and
the Rb groups are each independently H or an alkyl group optionally containing at least one substituent.

The organic group is preferably an alkyl group optionally containing at least one substituent.

The disclosure will be specifically described hereinbelow.

The modified fluororesin material of the disclosure contains a modified fluororesin containing a tetrafluoroethylene (TFE) unit, a modifying monomer unit based on a modifying monomer copolymerizable with TFE, and a tertiary carbon atom, the tertiary carbon atom being present in an amount of 0.001 to 0.100 mol% of the total amount of the TFE unit and the modifying monomer unit. Owing to the presence of a modified fluororesin containing a specific amount of a tertiary carbon atom together with the TFE unit and the modifying monomer unit, the modified fluororesin material of the disclosure characteristically is less likely to deform and has a low linear expansion coefficient.

The linear expansion coefficient varies according to the type of bond in a substance. The linear expansion coefficient of a substance having a covalent bond is lower than that of a substance having a weak bond such as an intermolecular force. The modified fluororesin of the disclosure contains a tertiary carbon atom. The presence of a tertiary carbon atom means that the modified fluororesin has a crosslinked structure. The crosslinked structure is a 3D network structure of molecular chains via strong covalent bonds. This covalent bond network can presumably reduce the linear expansion coefficient.

The amount of the tertiary carbon atom is preferably 0.005 mol% or more, more preferably 0.008 mol% or more, while preferably 0.080 mol% or less, more preferably 0.060 mol% or less, still more preferably 0.030 mol% or less of the total amount of the TFE unit and the modifying monomer unit.

The tertiary carbon atom is preferably a carbon atom coupled with F* in the structure represented by $-CF_2CF^*(-CF_2-)CF_2-$ in the modified fluororesin.

The amount of the tertiary carbon atom can be obtained by $^{19}F$-NMR measurement on the modified fluororesin to determine the peak intensities (peak integral values) A to C and calculation by the formula below.

$^{19}F$-NMR measurement conditions

Measurement device: solid-state $^{19}F$-NMR instrument available from Bruker

Measurement conditions: 282 MHz ($CF_2$ of modified fluororesin assigned to -120 ppm), spinning speed 30 kHz

Peak intensity A

The intensity of a peak observed at a chemical shift of -80 (-74 to -85) ppm and derived from five C-F* bonds of $-O-CF^*_2-$ and $-CF^*_3$ in a perfluoro(alkyl vinyl ether) (PAVE), which is a modifying monomer

Peak intensity B

The intensity of a peak observed at a chemical shift of -120 (-84 to -150) ppm with overlapping of five C-F* bonds in PAVE and four C-F* bonds derived from TFE

Peak intensity C

The intensity of a peak observed at a chemical shift of -183 (-178 to -191) ppm and assigned to F* derived from tertiary carbon $-CF_2CF^*(-CF_2-)CF_2-$

Formula

$$\text{Amount of tertiary carbon (mol\%)} = 100 \times (\text{peak intensity C})/\{(\text{peak intensity A}/5) + [\text{peak intensity B} - \text{peak intensity A}]/4 + (\text{peak intensity C})\}$$

In the case where the modifying monomer is a monomer other than PAVE, the amount of tertiary carbon can be determined by $^{19}F$-NMR measurement.

The modifying monomer may be any monomer copolymerizable with TFE, and examples thereof include hexafluoropropylene (HFP), a fluoroalkyl vinyl ether, a fluoroalkyl ethylene, a fluoromonomer represented by the formula (100) : $CH_2=CFRf^{101}$ (wherein $Rf^{101}$ is a C1-C12 linear or branched fluoroalkyl group), and a fluoroalkyl allyl ether.

The fluoroalkyl vinyl ether preferably includes at least one selected from the group consisting of:

a fluoromonomer represented by the formula (110):

$$CF_2=CF\text{-}ORf^{111}$$

wherein $Rf^{111}$ is a perfluoro organic group;
a fluoromonomer represented by the formula (120):

$$CF_2=CF\text{-}OCH_2\text{-}Rf^{121}$$

wherein $Rf^{121}$ is a C1-C5 perfluoroalkyl group;
a fluoromonomer represented by the formula (130):

$$CF_2=CFOCF_2ORf^{131}$$

wherein $Rf^{131}$ is a C1-C6 linear or branched perfluoroalkyl group, a C5-C6 cyclic perfluoroalkyl group, or a C2-C6 linear or branched perfluorooxyalkyl group containing one to three oxygen atoms;
a fluoromonomer represented by the formula (140):

$$CF_2=CFO(CF_2CF(Y^{141})O)_m(CF_2)_nF$$

wherein $Y^{141}$ is a fluorine atom or a trifluoromethyl group; m is an integer of 1 to 4; and n is an integer of 1 to 4; and
a fluoromonomer represented by the formula (150):

$$CF_2=CF\text{-}O\text{-}(CF_2CFY^{151}\text{-}O)_n\text{-}(CFY^{152})_m\text{-}A^{151}$$

wherein $Y^{151}$ is a fluorine atom, a chlorine atom, a $-SO_2F$ group, or a perfluoroalkyl group, where the perfluoroalkyl group optionally contains ether oxygen and a $-SO_2F$ group; n is an integer of 0 to 3; n $Y^{151}$s are the same as or different from each other; $Y^{152}$ is a fluorine atom, chlorine atom, or a $-SO_2F$ group; m is an integer of 1 to 5; m $Y^{152}$s are the same as or different from each other; $A^{151}$ is $-SO_2X^{151}$, $-COZ^{151}$, or $-POZ^{152}Z^{153}$, where $X^{151}$ is F, Cl, Br, I, $-OR^{151}$, or $-NR^{152}R^{153}$, and $Z^{151}$, $Z^{152}$, and $Z^{153}$ are the same as or different from each other and are each $-NR^{154}R^{155}$ or $-OR^{156}$; and $R^{151}$, $R^{152}$, $R^{153}$, $R^{154}$, $R^{155}$, and $R^{156}$ are the same as or different from each other and are each H, ammonium, an alkyl metal, or an alkyl group, aryl group, or sulfonyl-containing group optionally containing a fluorine atom.

The "perfluoro organic group" herein means an organic group in which all hydrogen atoms bonded to any carbon atom are replaced by fluorine atoms. The perfluoro organic group may contain ether oxygen.

An example of the fluoromonomer represented by the formula (110) may be a fluoromonomer in which $Rf^{111}$ is a C1-C10 perfluoroalkyl group. The carbon number of the perfluoroalkyl group is preferably 1 to 5.

Examples of the perfluoro organic group in the formula (110) include a perfluoromethyl group, a perfluoroethyl group, a perfluoropropyl group, a perfluorobutyl group, a perfluoropentyl group, and a perfluorohexyl group.

The fluoromonomer represented by the formula (110) may also be, for example, one represented by the formula (110) in which $Rf^{111}$ is a C4-C9 perfluoro(alkoxyalkyl) group; one in which $Rf^{111}$ is a group represented by the following formula:

[Chem. 1]

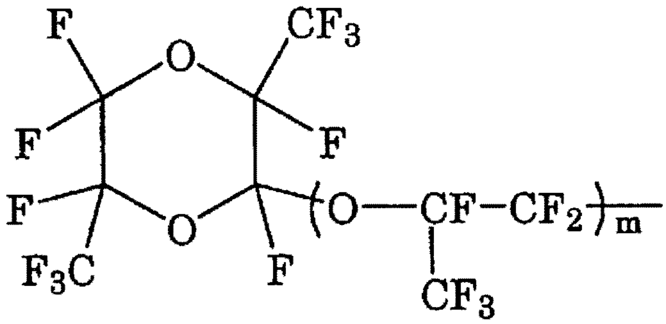

wherein m is 0 or an integer of 1 to 4; and one in which $Rf^{111}$ is a group represented by the following formula:

[Chem. 2]

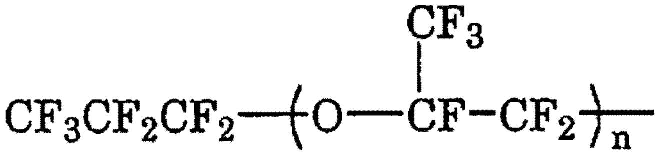

wherein n is an integer of 1 to 4.

In particular, the fluoromonomer represented by the formula (110) is preferably a perfluoro(alkyl vinyl ether) (PAVE), more preferably a fluoromonomer represented by the formula (160):

$CF_2=CF-ORf^{161}$

wherein $Rf^{161}$ is a C1-C10 perfluoroalkyl group. $Rf^{161}$ is preferably a C1-C5 perfluoroalkyl group.

The fluoroalkyl vinyl ether preferably includes at least one selected from the group consisting of fluoromonomers represented by any of the formulas (160), (130), and (140).

The fluoromonomer (PAVE) represented by the formula (160) preferably includes at least one selected from the group consisting of perfluoro(methyl vinyl ether) (PMVE), perfluoro(ethyl vinyl ether) (PEVE), and perfluoro(propyl vinyl ether) (PPVE), more preferably includes at least one selected from the group consisting of perfluoro(methyl vinyl ether) and perfluoro(propyl vinyl ether).

The fluoromonomer represented by the formula (130) preferably includes at least one selected from the group consisting of $CF_2=CFOCF_2OCF_3$, $CF_2=CFOCF_2OCF_2CF_3$, and $CF_2=CFOCF_2OCF_2CF_2OCF_3$.

The fluoromonomer represented by the formula (140) preferably includes at least one selected from the group consisting of $CF_2=CFOCF_2CF(CF_3)O(CF_2)_3F$, $CF_2=CFO(CF_2CF(CF_3)O)_2(CF_2)_3F$, and $CF_2=CFO(CF_2CF(CF_3)O)_2(CF_2)_2F$.

The fluoromonomer represented by the formula (150) preferably includes at least one selected from the group consisting of $CF_2=CFOCF_2CF_2SO_2F$, $CF_2=CFOCF_2CF(CF_3)OCF_2CF_2SO_2F$, $CF_2=CFOCF_2CF(CF_2CF_2SO_2F)OCF_2CF_2SO_2F$, and $CF_2=CFOCF_2CF(SO_2F)_2$.

The fluoromonomer represented by the formula (100) is preferably a fluoromonomer in which $Rf^{101}$ is a linear fluoroalkyl group, more preferably a fluoromonomer in which $Rf^{101}$ is a linear perfluoroalkyl group. $Rf^{101}$ preferably has a carbon number of 1 to 6. Examples of the fluoromonomer represented by the formula (100) include $CH_2=CFCF_3$, $CH_2=CFCF_2CF_3$, $CH_2=CFCF_2CF_2CF_3$, $CH_2=CFCF_2CF_2CF_2H$, $CH_2=CFCF_2CF_2CF_2CF_3$, $CHF=CHCF_3$ (E configuration), and $CHF=CHCF_3$ (Z configuration). Preferred among these is 2,3,3,3-tetrafluoropropylene represented by $CH_2=CFCF_3$.

The fluoroalkyl ethylene is preferably a fluoroalkyl ethylene represented by the formula (170):

$CH_2=CH-(CF_2)_n-X^{171}$

(wherein $X^{171}$ is H or F; and n is an integer of 3 to 10) ; and more preferably includes at least one selected from the group consisting of $CH_2=CH-C_4F_9$ and $CH_2=CH-C_6F_{13}$.

An example of the fluoroalkyl allyl ether is a fluoromonomer represented by the formula (180):

$CF_2=CF-CF_2-ORf^{111}$

wherein $Rf^{111}$ is a perfluoro organic group.

$Rf^{111}$ of the formula (180) is defined as described for $Rf^{111}$ of the formula (110). $Rf^{111}$ is preferably a C1-C10 perfluoroalkyl group or a C1-C10 perfluoroalkoxyalkyl group. The fluoroalkyl allyl ether represented by the formula (180) preferably includes at least one selected from the group consisting of $CF_2=CF-CF_2-O-CF_3$, $CF_2=CF-CF_2-O-C_2F_5$, $CF_2=CF-CF_2-O-C_3F_7$, and $CF_2=CF-CF_2-O-C_4F_9$, more preferably includes at least one selected from the group consisting of $CF_2=CF-CF_2-O-C_2F_5$, $CF_2=CF-CF_2-O-C_3F_7$, and $CF_2=CF-CF_2-O-C_4F_9$, and is still more preferably $CF_2=CF-CF_2-O-CF_2CF_2CF_3$.

In order to achieve much less deformation and much lower linear expansion coefficient of the modified fluororesin material, the modifying monomer is preferably a monomer containing a perfluorovinyl group, more preferably includes at least one selected from the group consisting of a perfluoro(alkyl vinyl ether) (PAVE), hexafluoropropylene (HFP), and perfluoroallyl ether, still more preferably includes at least one selected from the group consisting of PAVE and HFP. In order to reduce deformation of the modified fluororesin material during soldering, PAVE is particularly preferred.

The modified fluororesin preferably contains the modifying monomer unit(s) in a total amount of 0.1% by mass or more, more preferably 1.0% by mass or more, still more preferably 1.1% by mass or more of all monomer units. The total amount of the modifying monomer unit(s) is also preferably 30% by mass or less, more preferably 20% by mass or less, still more preferably 15% by mass or less, particularly preferably 10% by mass or less of all monomer units.

The amount of the modifying monomer unit is determined by $^{19}F$-NMR.

In the case where the modified fluororesin is a modified PFA containing a TFE unit and a PAVE unit, the PAVE unit is preferably contained in an amount of 0.1 to 12% by mass of all polymerized units. The amount of the PAVE unit is more preferably 0.3% by mass or more, still more preferably 0.7% by mass or more, further preferably 1.0% by mass or more, particularly preferably 1.1% by mass or more, while more preferably 8.0% by mass or less, still more preferably 6.5% by mass or less, particularly preferably 6.0% by mass or less of all polymerized units.

The amount of the PAVE unit is determined by $^{19}F$-NMR.

In the case where the modified fluororesin is a modified FEP containing a TFE unit and a HFP unit, the TFE unit and the HFP unit preferably have a mass ratio (TFE/HFP) of (70 to 99)/(1 to 30) (% by mass). The mass ratio (TFE/HFP) is more preferably (85 to 95)/(5 to 15) (% by mass).

The modified FEP contains the HFP unit in an amount of 1% by mass or more, preferably 1.1% by mass or more of all monomer units.

The modified FEP preferably contains a perfluoro(alkyl vinyl ether) (PAVE) unit as well as the TFE unit and the HFP unit.

Examples of the PAVE unit contained in the modified FEP include the same as the PAVE units to form the aforementioned modified PFA. Preferred among these is PPVE.

The aforementioned modified PFA does not contain a HFP unit and is therefore different from the modified FEP containing a PAVE unit.

In the case where the modified FEP contains a TFE unit, a HFP unit, and a PAVE unit, they preferably have a mass ratio (TFE/HFP/PAVE) of (70 to 99.8)/(0.1 to 25)/(0.1 to 25) (% by mass). The modified FEP having a mass ratio within this range can have excellent heat resistance and excellent chemical resistance.

The mass ratio (TFE/HFP/PAVE) is more preferably (75 to 98)/(1.0 to 15)/(1.0 to 10) (% by mass).

The modified FEP contains the HFP unit and the PAVE unit in a total amount of 1% by mass or more, preferably 1.1% by mass or more of all monomer units.

The modified FEP containing a TFE unit, a HFP unit, and a PAVE unit preferably contains the HFP unit in an amount of 25% by mass or less of all monomer units.

The HFP unit in an amount within the above range can lead to a modified fluororesin material having excellent heat resistance.

The amount of the HFP unit is more preferably 20% by mass or less, still more preferably 18% by mass or less, particularly preferably 15% by mass or less. The amount of the HFP unit is also preferably 0.1% by mass or more, more preferably 1% by mass or more, particularly preferably 2% by mass or more.

The amount of the HFP unit can be determined by $^{19}F$-NMR.

The amount of the PAVE unit is more preferably 20% by mass or less, still more preferably 10% by mass or less, particularly preferably 3% by mass or less. The amount of the PAVE unit is also preferably 0.1% by mass or more, more preferably 1% by mass or more. The amount of the PAVE unit can be determined by $^{19}F$-NMR.

The modified FEP may further contain a different ethylenic monomer ($\alpha$) unit.

The different ethylenic monomer ($\alpha$) unit may be any monomer unit copolymerizable with TFE, HFP, and PAVE. Examples thereof include fluorine-containing ethylenic monomers such as vinyl fluoride (VF), vinylidene fluoride (VdF), chlorotrifluoroethylene (CTFE), and ethylene (Et) and non-fluorinated ethylenic monomers such as ethylene, propylene,

and alkyl vinyl ethers.

In the case where the modified FEP contains a TFE unit, a HFP unit, a PAVE unit, and a different ethylenic monomer ($\alpha$) unit, they preferably have a mass ratio (TFE/HFP/PAVE/different ethylenic monomer ($\alpha$)) of (70 to 98)/(0.1 to 25)/(0.1 to 25)/(0.1 to 25) (% by mass).

The modified FEP contains the monomer units excluding the TFE unit in a total amount of 1% by mass or more, preferably 1.1% by mass or more of all monomer units.

The modified fluororesin also preferably includes the modified PFA and the modified FEP. In other words, the modified PFA and the modified FEP may be used as a mixture thereof. The modified PFA and the modified FEP preferably have a mass ratio (modified PFA/modified FEP) of 9/1 to 3/7, more preferably 9/1 to 5/5.

The modified fluororesin material of the disclosure has a linear expansion coefficient at 20°C to 200°C of 5% or more lower than that of a non-modified fluororesin material containing a TFE unit and a modifying monomer unit based on a modifying monomer copolymerizable with TFE and containing no tertiary carbon atom. This can reduce warpage of the modified fluororesin material. The linear expansion coefficient at 20°C to 200°C of the modified fluororesin material is preferably 10% or more lower, more preferably 13% or more lower, still more preferably 15% or more lower, particularly preferably 20% or more lower than that of the non-modified fluororesin material.

The linear expansion coefficient is measured by the method described in the EXAMPLES to be described later.

The non-modified fluororesin material preferably has the same structure as the modified fluororesin material except for the absence of tertiary carbon. The non-modified fluororesin material may be a fluororesin material before irradiated with a radiation in the production method to be described below.

The modified fluororesin material of the disclosure may further contain a different component as appropriate. Examples of the different component include additives such as a filler, a cross-linker, an antistatic agent, a heat-resistance stabilizer, a foaming agent, a foam nucleating agent, an antioxidant, a surfactant, a photopolymerization initiator, an anti-wear agent, a surface modifier, a resin other than the modified fluororesin, and a liquid crystal polymer.

The modified fluororesin material of the disclosure may further contain an inorganic filler as the different component. The presence of an inorganic filler can lead to improved properties such as electric properties, strength, and heat resistance. The modified fluororesin material of the disclosure may be a composite material containing the modified fluororesin and an inorganic filler.

Examples of the inorganic filler include, but are not limited to, inorganic compounds such as silica-class compounds (specifically, e.g., crystalline silica, fused silica, spherical fused silica), titanium oxide, zirconium oxide, zinc oxide, tin oxide, silicon nitride, silicon carbide, boron nitride, calcium carbonate, calcium silicate, potassium titanate, aluminum nitride, indium oxide, alumina, antimony oxide, cerium oxide, magnesium oxide, iron oxide, and tin-doped indium oxide (ITO). Examples also include minerals such as montmorillonite, talc, mica, boehmite, kaolin, smectite, xonotlite, vermiculite, and sericite. Other examples of the inorganic filler include carbon compounds such as carbon black, acetylene black, ketjen black, and carbon nanotube; metal hydroxides such as aluminum hydroxide and magnesium hydroxide; and glasses such as glass beads, glass flakes, and glass balloons.

One or two or more of these inorganic fillers may be used.

The inorganic filler in the form of powder may be used as it is or may be dispersed in a resin before use.

In order to achieve much improved properties such as electric properties, strength, and heat resistance, the inorganic filler preferably includes at least one selected from the group consisting of silica, alumina, titanium oxide, and talc, more preferably includes at least one selected from the group consisting of silica, alumina, and titanium oxide. Particularly preferred is silica because of its low specific gravity and low permittivity. The presence of silica can lead to a low thermal expansion coefficient of the fluororesin material. The presence of silica is also preferred because this effect can reduce warpage of a substrate and can lead to an improved peel strength of a coating layer.

The inorganic filler may have any shape, and may be in the form of particles, spheres, scales, needles, pillars, cones, pyramids, frustums, polyhedrons, or hollow matters, for example. Preferred among these are the forms of spheres, cubes, bowls, discs, octahedrons, scales, bars, plates, rods, tetrapods, and hollow matters, and more preferred are the forms of spheres, cubes, octahedrons, plates, and hollow matters. With the form of scales or needles, anisotropic filler pieces can be aligned to give higher adhesiveness. Spherical filler pieces are preferred because they have a small surface area and thus have a small influence on the properties of a fluororesin and less increase the viscosity when blended into a liquid.

The inorganic filler preferably has an average particle size of 0.1 to 20 um. The inorganic filler having an average particle size within the above range is less likely to aggregate and can give good surface roughness. The lower limit of the average particle size is more preferably 0.2 um, still more preferably 0.3 um. The upper limit of the average particle size is more preferably 5 $\mu$m, still more preferably 2 um.

The average particle size is a value measured by the laser diffraction scattering method.

The inorganic filler preferably has a maximum particle size of 10 um or smaller. The inorganic filler having a maximum particle size of 10 um or smaller is less likely to aggregate and can be well dispersed. Also, this inorganic filler allows the resulting fluororesin material to have a low surface sparseness. The maximum particle size is more preferably

5 um or smaller. The maximum particle size is determined from image data of 200 particles randomly selected in a SEM (scanning electron microscope) image using SEM image analysis software.

The inorganic filler may be a surface-treated one, and may be one surface-treated with a silicone compound. This surface treatment with a silicone compound can reduce the permittivity of the inorganic filler.

The silicone compound used may be, but is not limited to, a conventionally known silicone compound. For example, the silicone compound preferably contains at least one selected from the group consisting of a silane-coupling agent and an organosilazane.

The amount of surface-treating molecules of the silicone compound, which is expressed by the amount of the surface-treating agent reacted with the surface of the inorganic filler, is preferably 0.1 to 10 molecules, more preferably 0.3 to 7 molecules per unit surface area ($nm^2$).

The inorganic filler preferably has a specific surface area by the BET method, for example, of 1.0 to 25.0 $m^2/g$, more preferably 1.0 to 10.0 $m^2/g$, still more preferably 2.0 to 6.4 $m^2/g$. The inorganic filler having a specific surface area within this range is preferred because it is less likely to aggregate and has a smooth surface in the fluororesin material.

The modified fluororesin material of the disclosure may also contain a resin other than the modified fluororesin as the different component. The presence of a resin is expected to give effects of improving the strength and of reducing the linear expansion coefficient. The modified fluororesin material of the disclosure may be a composite material containing the modified fluororesin and a resin other than the modified fluororesin.

Examples of the resin include polyimides such as thermoplastic polyimide and thermosetting polyimide, polyamic acid, which is a precursor of the polyimides, poly(paraphenylenebenzoxazole), polybenzimidazole, and polyether ketone resin.

Examples of diamines and polycarboxylic dianhydrides of polyamic acid include those disclosed in paragraph [0020] of JP 5766125 B, paragraph [0019] of JP 5766125 B, and paragraphs [0055] and [0057] of JP 2012-145676 A. Preferred among these is a combination of an aromatic diamine such as 4,4'-diaminodiphenyl ether or 2,2-bis[4-(4-aminophenoxy)phenyl]propane and an aromatic polycarboxylic dianhydride such as pyromellitic dianhydride, 3,3',4,4'-biphenyltetracarboxylic dianhydride, or 3,3',4,4'-benzophenonetetracarboxylic dianhydride. One of diamines or one of derivatives thereof and one of polycarboxylic dianhydrides or one of derivatives thereof may be used alone or two or more of these may be used in combination.

In the case of a hot-melt resin or a resin to be cured into a hot-melt resin, the hot-melt resin preferably has a melting point of 280°C or higher. This promotes reduction of blisters (bubbles) generated by heat applied when an article such as a film formed from a fluororesin material is exposed to an atmosphere corresponding to reflow soldering.

Alternatively, the resin may be a resin containing a non-hot-melt polymer. Non-melting resins such as polytetrafluoroethylene (PTFE) and non-hot-melt resins such as resin formed from a cured product of thermosetting resin are dispersed in a fluororesin as in the case of the inorganic filler.

Examples of the thermosetting resin include epoxy resin, acrylic resin, phenol resin, polyester resin, polyolefin resin, modified polyphenylene ether resin, multifunctional cyanic acid ester resin, multifunctional maleimide-cyclic acid ester resin, multifunctional maleimide resin, vinyl ester resin, urea resin, diallyl phthalate resin, melamine resin, guanamine resin, melamine-urea co-condensed resin, and reactive group-containing fluororesin other than the modified fluororesin. In terms of usefulness for printed circuit boards, preferred among these thermosetting resins are epoxy resin, acrylic resin, bismaleimide resin, and modified polyphenylene ether resin, particularly preferred are epoxy resin and modified polyphenylene ether resin. One of these thermosetting resins may be used alone or two or more of these may be used in combination.

The epoxy resin may be any epoxy resin to be used for forming a variety of substrate material for printed circuit boards. Specific examples thereof include naphthalene epoxy resin, cresol novolac epoxy resin, bisphenol A epoxy resin, bisphenol F epoxy resin, bisphenol S epoxy resin, alicyclic epoxy resin, aliphatic chain epoxy resin, cresol novolac epoxy resin, phenol novolac epoxy resin, alkyl phenol novolac epoxy resin, aralkyl epoxy resin, biphenol epoxy resin, dicyclopentadiene epoxy resin, a tris(hydroxyphenyl)methane epoxy compound, an epoxidized compound of a condensate of a phenol and an aromatic aldehyde containing a phenolic hydroxy group, diglycidyl etherified bisphenol, diglycidyl etherified naphthalene diol, diglycidyl etherified phenol, diglycidyl etherified alcohol, and triglycidyl isocyanurate.

In addition to these, examples of the epoxy resin to be used include a variety of glycidyl ether epoxy resin, glycidyl amine epoxy resin, glycidyl ester epoxy resin, and oxidized epoxy resin, as well as phosphorus-modified epoxy resin. One of these epoxy resins may be used alone or two or more thereof may be used in combination. In particular, in order to achieve excellent curability, preferably used is an epoxy resin containing two or more epoxy groups in one molecule.

The epoxy resin preferably has a weight average molecular weight of 100 to 1000000, more preferably 1000 to 100000. The epoxy resin having a weight average molecular weight within this range can have excellent interlayer adhesion between an article such as a film formed from the modified fluororesin material and a different material (e.g., metal). The weight average molecular weight of the epoxy resin is measured by gel permeation chromatography (GPC) .

Examples of the bismaleimide resin include a resin composition (BT resin) of bisphenol A cyanic acid ester

resin and a bismaleimide compound, as disclosed in JP H7-70315 A, and the invention and those disclosed in the background art of WO 2013/008667.

In the case where the resin used includes a thermosetting resin, the modified fluororesin material of the disclosure may contain a curing agent. Examples of the curing agent include a heat-curing agent (e.g., melamine resin, urethane resin) and an epoxy curing agent (e.g., novolac phenol resin, isophthalic dihydrazide, adipic dihydrazide).

In order to achieve much better effects of improving the strength and of reducing the linear expansion coefficient, the resin preferably includes at least one selected from the group consisting of poly(paraphenylenebenzoxazole), polybenzimidazole, polyimide, epoxy resin, and polytetrafluoroethylene.

The different component is preferably contained in an amount of 60% by mass or less, more preferably 50% by mass or less, still more preferably 40% by mass or less of the modified fluororesin material. Too large an amount of the different component may cause impaired electric properties. The amount of the different component is also preferably 15% by mass or more of the modified fluororesin material.

The modified fluororesin material also preferably consists only of the modified fluororesin.

The modified fluororesin material of the disclosure can be suitably produced by a production method including (1) irradiating a fluororesin with radiation at an irradiation temperature that is 5°C or more lower than the melting point of the fluororesin, the fluororesin being a copolymer containing a TFE unit and a modifying monomer unit based on a modifying monomer copolymerizable with TFE. The disclosure also provides this production method.

The irradiation temperature is preferably a temperature that is more than 20°C lower, more preferably 25°C or more lower, still more preferably 35°C or more lower than the melting point of the fluororesin. The irradiation temperature is also preferably 0°C or higher, more preferably room temperature or higher, still more preferably 80°C or higher, further preferably 100°C or higher, particularly preferably 150°C or higher, most preferably 200°C or higher.

Examples of the radiation include electron beams, ultraviolet rays, gamma rays, X-rays, neutron beams, and high-energy ions. Preferred among these are electron beams because of their excellent penetrating power, high dose rate, and suitability for industrial production.

The radiation may be applied by any method, such as a method of using a conventionally known irradiation device.

The radiation is preferably applied at a dose of 10 kGy to 250 kGy. Too low a dose may cause insufficient generation of radicals involved in the crosslinking reaction, resulting in an insufficient crosslinking effect. Too high a dose may cause scission of the main chain of a fluororesin into small molecules, resulting in significantly poor mechanical strength.

The dose of the radiation is more preferably 20 kGy or higher, still more preferably 30 kGy or higher, while more preferably 100 kGy or lower, still more preferably 90 kGy or lower, particularly preferably 80 kGy or lower.

The radiation may be applied in any irradiation environment, preferably at an oxygen concentration of 1000 ppm or lower, more preferably in the absence of oxygen, still more preferably in a vacuum or in an atmosphere of inert gas such as nitrogen, helium, or argon.

Examples of the modifying monomer copolymerizable with TFE in the fluororesin include the same as the modifying monomers for the aforementioned modified fluororesin material of the disclosure.

The fluororesin is preferably a melt-fabricable fluororesin. The term "melt-fabricable" herein means that a polymer can be processed in a molten state using a conventional processing device such as an extruder or an injection-molding machine.

In order to achieve much less deformation and much lower linear expansion coefficient of the modified fluororesin material, the fluororesin is preferably a copolymer of tetrafluoroethylene (TFE) and a monomer containing a perfluorovinyl group, more preferably includes at least one selected from the group consisting of a TFE/perfluoro(alkyl vinyl ether) (PAVE) copolymer (PFA), a TFE/hexafluoropropylene (HFP) copolymer (FEP), and a TFE/perfluoroallyl ether copolymer, still more preferably includes at least one selected from the group consisting of PFA and FEP. Particularly preferred is PFA because it has a high melting point and does not deform during soldering.

The PFA is a copolymer containing a TFE unit and a PAVE unit and may be a copolymer consisting only of a TFE unit and a PAVE unit. The monomer units of the PFA and the amounts thereof are the same as those for the aforementioned modified PFA.

The PFA preferably has a melting point of 280°C to 322°C. The melting point is more preferably 290°C or higher while more preferably 315°C or lower.

The melting point is the temperature corresponding to the maximum value on a heat-of-fusion curve with a temperature-increasing rate of 10°C/min using a differential scanning calorimeter (DSC).

The PFA preferably has a glass transition temperature (Tg) of 70°C to 110°C. The glass transition temperature is more preferably 80°C or higher and more preferably 100°C or lower.

The glass transition temperature is a value obtained by dynamic viscoelasticity measurement.

The PFA may be produced, for example, by a conventionally known method in which monomers to serve as the structural units and additives such as a polymerization initiator are mixed with each other as appropriate, followed

by emulsion polymerization or suspension polymerization.

The FEP is a copolymer containing a TFE unit and a HFP unit. The monomer units of the FEP and the amounts thereof are the same as those for the aforementioned modified FEP.

The FEP preferably has a melting point of 200°C to 322°C. Too low a melting point may cause an insufficient effect of applying radiation. Too high a melting point may cause scission of the main chain of a fluororesin into small molecules, resulting in significantly poor mechanical strength. The melting point is more preferably higher than 200°C, still more preferably 220°C or higher, while more preferably 300°C or lower, still more preferably 280°C or lower. The melting point is the temperature corresponding to the maximum value on a heat-of-fusion curve with a temperature-increasing rate of 10°C/min using a differential scanning calorimeter (DSC).

The FEP preferably has a glass transition temperature (Tg) of 60°C to 110°C, more preferably 65°C or higher, while more preferably 100°C or lower. The glass transition temperature is a value obtained by dynamic viscoelasticity measurement.

The FEP may be produced, for example, by a conventionally known method in which monomers to serve as the structural units and additives such as a polymerization initiator are mixed with each other as appropriate, followed by emulsion polymerization, solution polymerization, or suspension polymerization.

The fluororesin also preferably includes the PFA and the FEP. In other words, the PFA and the FEP may be used as a mixture thereof. The PFA and the FEP preferably have a mass ratio (PFA/HFP) of 9/1 to 3/7, more preferably 9/1 to 5/5.

The mixture may be favorably prepared by a known method, such as a method including melt-mixing (melt-kneading) two or more of the fluororesins having different melting points or a method including mixing a resin dispersion after emulsion polymerization, coagulating the resin with an acid such as nitric acid, and collecting the resin. The melt mixing can be performed at a temperature that is equal to or higher than the highest melting point among the melting points of the two or more fluororesins having different melting points.

The fluororesin preferably has a melt flow rate (MFR) at 372°C of 0.1 to 100 g/10 min. The MFR within this range can lead to a significant effect of applying radiation. The MFR is more preferably 0.5 g/10 min or higher, while more preferably 80 g/10 min or lower, still more preferably 40 g/10 min or lower. The MFR is a value obtained in conformity with ASTM D1238 using a melt indexer (available from Yasuda Seiki Seisakusho Ltd.), as the mass (g/10 min) of a polymer flowing out of a nozzle (inner diameter: 2 mm, length: 8 mm) per 10 minutes at a temperature of 372°C and a load of 5 kg.

In the case of producing a modified fluororesin material further containing the aforementioned different component, a mixture of the fluororesin and the different component may be irradiated with radiation or the modified fluororesin material and the different component may be mixed with each other.

A modified fluororesin material containing, as the different component, at least one selected from the group consisting of an inorganic filler and a resin other than the modified fluororesin may suitably be produced, for example, by a production method in which the step (1) includes irradiating a mixture with the radiation, the mixture containing the fluororesin and at least one selected from the group consisting of an inorganic filler and a resin other than the fluororesin.

A modified fluororesin material containing as the different component at least one selected from the group consisting of an inorganic filler and a resin other than the modified fluororesin may also suitably be produced, for example, by a production method including (2) mixing the modified fluororesin and at least one selected from the group consisting of an inorganic filler and a resin other than the fluororesin. The disclosure also provides this production method.

The modified fluororesin may be one obtained in the aforementioned step (1).

Each of the aforementioned production methods may further include molding the fluororesin or the modified fluororesin material. Molding may be followed by the aforementioned irradiation with radiation.

The molding may be performed by any of known methods such as extrusion molding, injection molding, transfer molding, inflation, and compression molding. These molding methods may be selected as appropriate according to the target shape of the modified fluororesin material.

The disclosure also provides a material for a circuit board containing the aforementioned modified fluororesin material of the disclosure.

The material for a circuit board may consist only of the modified fluororesin material.

The material for a circuit board may be in any form, and is preferably in the form of a sheet.

The sheet preferably has a thickness of 5 to 3000 μm, more preferably 5 to 2000 μm.

The material for a circuit board may be surface-modified on one or both of the surfaces. Surface modification is preferred in that it can provide improved adhesion with a metal layer such as copper foil.

A specific method of the surface modification may be, but is not limited to, any known method. Specifically, corona discharge treatment, glow discharge treatment, plasma discharge treatment, or discharge treatment by sputtering may be used. For example, surface modification may be achieved by introducing oxygen gas, nitrogen gas, hydrogen gas, or the like into the discharge atmosphere to control the surface free energy. Alternatively, surface modification may be achieved by exposing the surface to be modified to an inert gas (e.g., nitrogen gas, helium gas, argon gas) atmosphere

containing an organic compound, applying a high-frequency voltage between the electrodes to cause discharge, which generates active species on the surface, and then introducing the functional group of the organic compound onto the surface or graft-polymerizing the polymerizable organic compound to the surface.

The surface modification is particularly suitable for the case where the material for a circuit board is in the form of a sheet.

The material for a circuit board of the disclosure is to be used for a circuit board, particularly preferably used for an insulation layer of a circuit board.

The circuit board is preferably a printed circuit board. The printed circuit board may be a rigid circuit board, a flexible circuit board, or a rigid flexible circuit board.

The circuit board is preferably a high frequency circuit board. The high frequency circuit board is a circuit board that is operable in a high frequency band. The high frequency band may be a band of 1 GHz or more, preferably a band of 3 GHz or more, more preferably a band of 5 GHz or more. The upper limit may be, but is not limited to, a band of 100 GHz or less.

The material for a circuit board of the disclosure can suitably be used for a circuit board for the 5th generation mobile communication system.

The disclosure also relates to a laminate for a circuit board including a metal layer (A1) and a layer (B) containing the aforementioned material for a circuit board of the disclosure.

The metal layer (A1) preferably contains as a metal component thereof at least one selected from the group consisting of copper, stainless steel, aluminum, iron, and an alloy of any of these, more preferably contains at least one selected from the group consisting of copper, stainless steel, and aluminum, and still more preferably contains copper.

Examples of the stainless steel include austenite stainless steel, martensite stainless steel, and ferrite stainless steel.

The metal layer (A1) may be a layer formed by sputtering, vacuum deposition, electroplating, electroless plating, or the like, or may be a layer of metal foil.

In the case where the metal layer (A1) is a layer of metal foil, the metal layer (A1) may be formed by bonding the metal foil to the layer (B) by hot pressing.

The metal layer (A1) may have a thickness of 2 to 200 um, preferably 5 to 50 μm, for example.

The metal layer (A1) may be provided on one side of the layer (B) or may be provided on both sides thereof.

The layer (B) contains the material for a circuit board of the disclosure. The layer (B) is preferably in the form of a sheet containing the material for a circuit board of the disclosure. The layer (B) may be formed separately from the metal layer (A1) in advance, or may be formed by stacking the fluororesin and the metal layer (A1) and then irradiating this fluororesin with radiation.

The layer (B) may be subjected to the aforementioned surface modification on one or both of the surfaces.

The layer (B) may have a thickness of 1 um to 1 mm, preferably 1 to 500 μm, for example. The thickness is more preferably 150 um or smaller, still more preferably 100 um or smaller.

In addition to the metal layer (A1) and the layer (B), the laminate of the disclosure may further include a different layer. In order to achieve good electric properties and to provide a thin film, the layer (B) is preferably not provided with the different layer on the surface opposite to the metal layer (A1).

The laminate of the disclosure is preferably in the form of a sheet. The laminate of the disclosure preferably has a thickness of 10 to 3500 μm, more preferably 20 to 3000 μm.

The laminate of the disclosure may suitably be used as a metal clad laminate for forming a circuit board, for example.

The disclosure also relates to a circuit board including a metal layer (A2) and a layer (B) containing the aforementioned material for a circuit board of the disclosure.

Examples of the metal component of the metal layer (A2), as well as the thickness thereof, are the same as those for the metal layer (A1).

The layer (B) is the same as the layer (B) in the laminate of the disclosure.

The metal layer (A2) preferably defines the circuit. The circuit pattern may be formed by any method, such as a method in which a metal layer without a pattern is formed on the layer (B) and is then etched to have a pattern; a method in which a metal layer is formed on the layer (B) directly at portions necessary for the circuit pattern; or a method of combination of these. In either case, a conventionally known method may be used.

The circuit board of the disclosure may be one obtainable by patterning the metal layer (A1) in the laminate of the disclosure.

The metal layer (A2) may be provided on one side of the layer (B) or may be provided on both sides thereof. The layer (B) may be subjected to the aforementioned surface modification on one or both of the surfaces.

In addition to the metal layer (A2) and the layer (B), the circuit board of the disclosure may further include a different layer. In order to achieve good electric properties and to provide a thin film, the layer (B) is preferably not provided with the different layer on the surface opposite to the metal layer (A2).

The circuit board of the disclosure is preferably in the form of a sheet. The circuit board of the disclosure preferably has a thickness of 10 to 3500 μm, more preferably 20 to 3000 μm.
The circuit board of the disclosure is preferably a printed circuit board. The printed circuit board is defined as described above.
The circuit board of the disclosure is also preferably a high frequency circuit board. The high frequency circuit board is defined as described above.
The circuit board of the disclosure is also preferably a circuit board for the 5th generation mobile communication system.

EXAMPLES

The disclosure is described in more detail below with reference to examples, but is not limited to these examples.
The physical properties were determined by the following methods.

(Amounts of monomer units)

The amounts of the monomer units were determined by $^{19}F$-NMR.

(MFR)

The MFR was obtained in conformity with ASTM D1238 using a melt indexer (available from Yasuda Seiki Seisakusho Ltd.), as the mass (g/10 min) of a polymer flowing out of a nozzle (inner diameter: 2 mm, length: 8 mm) per 10 minutes at a temperature of 372°C and a load of 5 kg.

(Glass transition temperature)

The glass transition temperature was determined by dynamic viscoelasticity measurement using DVA-220 (available from IT Keisoku Seigyo, Co. Ltd.).
A sample test piece used was a compression-molded sheet having a length of 25 mm, a width of 5 mm, and a thickness of 0.2 mm. The measurement was performed at a temperature-increasing rate of 2°C/min and a frequency of 10 Hz. The temperature at the peak of tanδ was defined as the glass transition temperature.

(Melting point)

The temperature corresponding to the maximum value on a heat-of-fusion curve with a temperature-increasing rate of 10°C/min using a differential scanning calorimeter (DSC) was defined as the melting point.

(Linear expansion coefficient)

The linear expansion coefficient was determined by TMA measurement using TMA-7100 (available from Hitachi High-Tech Corp.) in the compression mode.

(Compression mode measurement)

A sample piece used was a compression-molded sheet having a length of 6 mm, a width of 6 mm, and a thickness of 2 mm. A load of 49 mN was applied to the sample piece at a temperature-increasing rate of 2°C/min from 20°C to 200°C. Based on the displacement of the sample, the linear expansion coefficient was determined.

(Amount of tertiary carbon)

The amount of tertiary carbon was determined by $^{19}F$-NMR measurement. The calculation method is as described above.

Example 1

A tetrafluoroethylene (TFE)/perfluoro(propyl vinyl ether) (PPVE) copolymer (TFE/PPVE = 94.5/5.5 (% by mass), MFR: 30 g/10 min, melting point: 302°C) (PFA1) was processed into a 2-mm-thick sheet using a heat press molding machine. The sheet was then cut to provide a test piece having a width of 20 mm and a length of 20 mm.

The resulting test piece was placed in an electron beam irradiation chamber of an electron beam processing system (available from NHV Corp.). Nitrogen gas was then introduced into the chamber to make a nitrogen atmosphere. The temperature inside the chamber was controlled to and stabilized at 255°C, and electron beams were then applied to the test piece at a dose of 40 kGy with an electron beam accelerating voltage of 3000 kV and a dose intensity of 20 kGy/5 min, whereby a modified fluororesin material was obtained. This modified fluororesin material was cut to provide a sample having a width of 6 mm and a length of 6 mm while the thickness was maintained at 2 mm. This sample had a linear expansion coefficient of 165 ppm, which was 14% lower than the linear expansion coefficient of a sample without electron beam irradiation (Comparative Example 1), and contained tertiary carbon in an amount of 0.010 mol% of the total amount of the TFE unit and the PPVE unit.

The modified fluororesin material obtained above was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Example 2

A modified fluororesin material was obtained as in Example 1 except that the electron beam irradiation temperature was 245°C. This modified fluororesin material had a linear expansion coefficient of 178 ppm, which was 7% lower than the linear expansion coefficient of a sample without electron beam irradiation (Comparative Example 1), and contained tertiary carbon in an amount of 0.007 mol% of the total amount of the TFE unit and the PPVE unit.

The modified fluororesin material obtained above was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Example 3

A modified fluororesin material was obtained as in Example 1 except that the electron beam irradiation temperature was 270°C. This modified fluororesin material had a linear expansion coefficient of 183 ppm, which was 6% lower than the linear expansion coefficient of a sample without electron beam irradiation (Comparative Example 1), and contained tertiary carbon in an amount of 0.046 mol% of the total amount of the TFE unit and the PPVE unit.

The modified fluororesin material obtained above was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Example 4

A modified fluororesin material was obtained as in Example 1 except that PFA1 was replaced by PFA2 containing 80% by mass of a tetrafluoroethylene (TFE)/perfluoro(propyl vinyl ether) (PPVE) copolymer (TFE/PPVE = 98.5/1.5 (% by mass), MFR: 14 g/10 min, melting point: 306°C) and 20% by mass of silica (ADMAFINE SC2500-SQ available from Admatechs Co., Ltd., average particle size: 0.5 um, specific surface area: 6.1 $m^2/g$). This modified fluororesin material had a linear expansion coefficient of 103 ppm, which was 24% lower than the linear expansion coefficient of a sample without electron beam irradiation (Comparative Example 2), and contained tertiary carbon in an amount of 0.011 mol% of the total amount of the TFE unit and the PPVE unit.

The modified fluororesin material obtained above was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Example 5

A tetrafluoroethylene (TFE)/perfluoro(propyl vinyl ether) (PPVE) copolymer (TFE/PPVE = 98.5/1.5 (% by mass), MFR: 15 g/10 min, melting point: 306°C) (PFA3) was melt-extrusion-molded into a 0.056-mm-thick film. This film was then cut to provide a test piece having a width of 280 mm and a length of 370 mm.

The resulting test piece was placed on an aluminum frame (width 270 mm × depth 330 mm × height 25 mm) and, on the four peripheral sides of the film, aluminum weights (width direction: 20 mm × 270 mm × 6 mm, 88 g, longitudinal direction: 20 mm × 330 mm × 6 mm, 106 g) were fixed with clips to apply a tension. In this state, the workpiece was placed in an electron beam irradiation chamber of an electron beam processing system (available from NHV Corp.). Nitrogen gas was then introduced into the chamber to make a nitrogen atmosphere. The temperature inside the chamber was controlled to and stabilized at 255°C and electron beams were then applied to the test piece at a dose of 56 kGy with an electron beam accelerating voltage of 3000 kV and a dose intensity of 20 kGy/5 min, whereby a

modified fluororesin material was obtained. This modified fluororesin material was cut to provide a strip-shaped sample having a width of 2 mm and a length of 18 mm while the thickness was maintained at 0.056 mm. This sample had a linear expansion coefficient of 188 ppm, which was 12% lower than the linear expansion coefficient of a sample without electron beam irradiation (Comparative Example 3), and contained tertiary carbon in an amount of 0.013 mol% of the total amount of the TFE unit and the PPVE unit.

The modified fluororesin material obtained above was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Example 6

PFA1 was processed into a 0.215-mm-thick sheet using a heat press molding machine. The sheet was then cut to provide a strip-shaped test piece having a width of 12.5 mm and a length of 130 mm. This test piece was bonded to a 100-mm-square copper foil by vacuum press (under reduced pressure with a vacuum pump, the sheet was heated up to 320°C, pressurized at 15 kN, and maintained for five minutes).

The resulting PFA sheet with copper foil was irradiated with electron beams as in Example 1, whereby a laminate for a circuit board was obtained.

Comparative Example 1

PFA1 was processed into a 2-mm-thick sheet using a heat press molding machine. The sheet was then cut to provide a strip-shaped test piece having a width of 6 mm and a length of 6 mm. This test piece had a linear expansion coefficient of 191 ppm and contained tertiary carbon in an amount of 0.000 mol% of the total amount of the TFE unit and the PPVE unit.

This test piece was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Comparative Example 2

PFA2 was processed into a 2-mm-thick sheet using a heat press molding machine. The sheet was then cut to provide a strip-shaped test piece having a width of 6 mm and a length of 6 mm. This test piece had a linear expansion coefficient of 135 ppm and contained tertiary carbon in an amount of 0.000 mol% of the total amount of the TFE unit and the PPVE unit.

This test piece was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Comparative Example 3

PFA3 was processed into a 0.056-mm-thick film using a melt-extrusion-molding machine. This film was then cut to provide a strip-shaped test piece having a width of 2 mm and a length of 18 mm. This test piece had a linear expansion coefficient of 213 ppm and contained tertiary carbon in an amount of 0.000 mol% of the total amount of the TFE unit and the PPVE unit.

This test piece was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

Comparative Example 4

A modified fluororesin material was obtained as in Example 1 except that the electron beam irradiation temperature was 320°C and the dose was 40 kGy. This modified fluororesin material had a linear expansion coefficient of 193 ppm, which was 1% lower than the linear expansion coefficient of a sample without electron beam irradiation (Comparative Example 1) and contained tertiary carbon in an amount of 0.115 mol% of the total amount of the TFE unit and the PPVE unit.

The modified fluororesin material obtained above was bonded to a 100-mm-square copper foil by vacuum press (under reduced pressure with a vacuum pump, the sheet was heated up to 320°C, pressurized at 15 kN, and maintained for five minutes), whereby a laminate for a circuit board was obtained.

The above results clearly demonstrates that electron beam irradiation can reduce the linear expansion coefficient of a modified fluororesin material and thereby can lead to a good laminate for a circuit board.

## Claims

1. A modified fluororesin material comprising

    a modified fluororesin, the modified fluororesin comprising:

    a tetrafluoroethylene unit;
    a modifying monomer unit based on a modifying monomer copolymerizable with tetrafluoroethylene; and
    a tertiary carbon atom, the tertiary carbon atom being present in an amount of 0.001 to 0.100 mol% of a total amount of the tetrafluoroethylene unit and the modifying monomer unit,

    the modified fluororesin material having a linear expansion coefficient at 20°C to 200°C that is 5% or more lower than that of a non-modified fluororesin material, the non-modified fluororesin material containing a tetrafluoroethylene unit and a modifying monomer unit based on a modifying monomer copolymerizable with tetrafluoroethylene and containing no tertiary carbon atom.

2. The modified fluororesin material according to claim 1,
wherein the linear expansion coefficient at 20°C to 200°C of the modified fluororesin material is 10% or more lower than that of the non-modified fluororesin material.

3. The modified fluororesin material according to claim 1 or 2,
wherein the tertiary carbon atom is a carbon atom coupled with F* in a structure represented by $-CF_2CF^*(-CF_2-)CF_2-$ in the modified fluororesin.

4. The modified fluororesin material according to any one of claims 1 to 3,
wherein the modifying monomer is a monomer containing a perfluorovinyl group.

5. The modified fluororesin material according to claim 4,
wherein the monomer containing a perfluorovinyl group includes at least one selected from the group consisting of a perfluoro(alkyl vinyl ether), hexafluoropropylene, and perfluoroallyl ether.

6. The modified fluororesin material according to any one of claims 1 to 5, further comprising an inorganic filler.

7. The modified fluororesin material according to claim 6,
wherein the inorganic filler includes at least one selected from the group consisting of silica, alumina, titanium oxide, and talc.

8. The modified fluororesin material according to any one of claims 1 to 7, further comprising a resin other than the modified fluororesin.

9. The modified fluororesin material according to claim 8,
wherein the resin other than the modified fluororesin includes at least one selected from the group consisting of poly(paraphenylenebenzoxazole), polybenzimidazole, polyimide, epoxy resin, and polytetrafluoroethylene.

10. A material for a circuit board, the material comprising the modified fluororesin material according to any one of claims 1 to 9.

11. The material for a circuit board according to claim 10,
wherein the material is in a form of a sheet.

12. The material for a circuit board according to claim 10 or 11,
wherein the material is in a form of a sheet having a thickness of 5 to 3000 um.

13. A laminate for a circuit board, the laminate comprising:

a metal layer (A1); and
a layer (B) comprising the material for a circuit board according to any one of claims 10 to 12.

**14.** The laminate for a circuit board according to claim 13,
wherein the metal layer (A1) contains copper as a metal component thereof.

**15.** The laminate for a circuit board according to claim 13 or 14,
wherein the laminate is in a form of a sheet having a thickness of 10 to 3500 um.

**16.** A circuit board comprising:

a metal layer (A2); and
a layer (B) comprising the material for a circuit board according to any one of claims 10 to 12.

**17.** The circuit board according to claim 16,
wherein the metal layer (A2) contains copper as a metal component thereof.

**18.** The circuit board according to claim 16 or 17,
wherein the circuit board is in a form of a sheet having a thickness of 10 to 3500 um.

**19.** The circuit board according to any one of claims 16 to 18,
wherein the circuit board is a printed circuit board.

**20.** A method for producing the modified fluororesin material according to any one of claims 1 to 9, the method comprising:

(1) irradiating a fluororesin with radiation at an irradiation temperature that is 5°C or more lower than a melting point of the fluororesin, the fluororesin being a copolymer containing a tetrafluoroethylene unit and a modifying monomer unit based on a modifying monomer copolymerizable with tetrafluoroethylene.

**21.** The production method according to claim 20,
wherein the step (1) includes irradiating a mixture with the radiation, the mixture containing the fluororesin and at least one selected from the group consisting of an inorganic filler and a resin other than the fluororesin.

**22.** The production method according to claim 20 or 21,
wherein the radiation is applied at a dose of 10 kGy to 250 kGy.

**23.** The production method according to any one of claims 20 to 22,
wherein the radiation is an electron beam.

**24.** A method for producing the modified fluororesin material according to any one of claims 1 to 9, the method comprising:
(2) mixing the modified fluororesin and at least one selected from the group consisting of an inorganic filler and a resin other than the modified fluororesin.

## INTERNATIONAL SEARCH REPORT

International application No.
**PCT/JP2022/004759**

**A. CLASSIFICATION OF SUBJECT MATTER**

***C08J 7/00***(2006.01)i; ***C08F 214/26***(2006.01)i; ***H05K 1/03***(2006.01)i
FI: C08J7/00 302; C08F214/26; C08J7/00 CEW; H05K1/03 610H; H05K1/03 630H

According to International Patent Classification (IPC) or to both national classification and IPC

**B. FIELDS SEARCHED**

Minimum documentation searched (classification system followed by classification symbols)

C08J7/00-7/02; C08J7/12-7/18; C08F6/00-246/00; C08F301/00; B29C71/04; H05K1/03

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2019/187725 A1 (DAIKIN INDUSTRIES LTD.) 03 October 2019 (2019-10-03) claims, paragraphs [0065], [0071]-[0073], [0080]-[0102], table 3, examples 1-8 | 1-5, 8-20, 22-24 |
| Y | | 6-7, 10-19, 21-24 |
| X | WO 2018/043003 A1 (DAIKIN INDUSTRIES LTD.) 08 March 2018 (2018-03-08) claims, paragraphs [0066]-[0071], [0091]-[0098], tables 1, 2, experimental examples | 1-5, 8-9, 20-23 |
| Y | | 10-19 |
| A | | 6-7, 24 |
| Y | WO 2020/145133 A1 (DAIKIN INDUSTRIES, LTD.) 16 July 2020 (2020-07-16) paragraphs [0037], [0040] | 6-7, 21-24 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 March 2022** | **29 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/004759**

| Patent document cited in search report | Publication date (day/month/year) | Patent family member(s) | Publication date (day/month/year) |
|---|---|---|---|
| WO 2019/187725 A1 | 03 October 2019 | US 2021/0024769 A1<br>claims, paragraphs [0071], [0077]-[0079], [0086]-[0131], examples, table 3<br>CN 111886284 A | |
| WO 2018/043003 A1 | 08 March 2018 | US 2019/0218320 A1<br>claims, paragraphs [0064]-[0069], [0090]-[0097], examples, tables 1, 2<br>CN 109642038 A<br>TW 201827495 A | |
| WO 2020/145133 A1 | 16 July 2020 | CN 112585007 A<br>TW 202031779 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015008260 A
- JP 2015008286 A
- JP 5766125 B
- JP 2012145676 A
- JP H770315 A
- WO 2013008667 A